# EUROPÄISCHE PATENTSCHRIFT

(11) **EP 2 018 703 B1**
(45) Veröffentlichungstag und Bekanntmachung des Hinweises auf die Patenterteilung: **14.11.2012**
(21) Anmeldenummer: 07725108.0
(22) Anmeldetag: 11.05.2007
(51) Int. Cl.: H03K 17/96

(54) **BEDIENEINHEIT FÜR HAUSHALTSGERÄTE**
OPERATING UNIT FOR DOMESTIC APPLIANCES
UNITE DE COMMANDE POUR APPAREILS MENAGERS

(30) Priorität: 12.05.2006 DE 102006022965
(43) Veröffentlichungstag der Anmeldung: 28.01.2009
(73) Patentinhaber: E.G.O. ELEKTRO-GERÄTEBAU GmbH, 75038 Oberderdingen (DE)
(72) Erfinder: ROTH, Bernhard, 75038 Oberderdingen (DE)
(74) Vertreter: Patentanwälte Ruff, Wilhelm, Beier, Dauster & Partner
(86) Internationale Anmeldenummer: PCT/EP2007/004188
(87) Internationale Veröffentlichungsnummer: WO 2007/131717

(56) Entgegenhaltungen:
- EP-A- 1 355 425
- EP-A1- 1 542 363
- DE-A1- 10 326 684
- US-A1- 2003 210 537

## Beschreibung

### Anwendungsgebiet und Stand der Technik

Die Erfindung betrifft eine Bedieneinheit für Haushaltsgeräte, insbesondere für Kochfelder, zum Einbau hinter einer Blende des Haushaltsgeräts.

Derartige Bedieneinheiten umfassen üblicherweise Bedienelemente zur Steuerung von Funktionen des Haushaltsgeräts. Bei Kochfeldern kann beispielsweise für die Bedienung der jeweiligen Kochstellen des Kochfeldes ein Bedienelement für die Aktivierung bzw. Deaktivierung der Kochstelle und ein Bedienelement zur Leistungseinstellung vorgesehen sein.

Bei Kochfeldern kann die Bedieneinheit innerhalb bzw. am Rand der so genannten Kochmulde, hinter einer Blende in Form einer Glaskeramikplatte vorgesehen sein. Als Bedienelemente dienen hierbei üblicherweise kapazitive Sensorelemente, deren Kapazität sich abhängig von einer Betätigung bzw. Bedienung verändert. Diese Kapazitätsänderung kann von einer zugehörigen Steuereinheit verarbeitet und in entsprechende Steuerbefehle umgesetzt werden.

Da derartige kapazitive Bedienelemente üblicherweise keine taktile Rückmeldung bei einer Betätigung liefern, sind den Bedienelementen bzw. den Sensorelementen Leuchtmittel, beispielsweise LEDs, zugeordnet, deren optischer Zustand dem Betätigungszustand entsprechen kann oder die eine durch Betätigung bewirkte Aktivierung bzw. Deaktivierung oder Leistungseinstellung visualisieren können.

Eine derartige Bedieneinheit mit beleuchteten bzw. hintergrundbeleuchteten, kapazitiven Bedienelementen bzw. Sensorelementen ist aus der

DE 103 26 684 A1 bekannt. Die Bedieneinheit ist zum Einbau hinter einer Blende in Form einer Glaskeramikplatte des Haushaltsgeräts vorgesehen und weist ein durchsichtiges, kapazitives Sensorelement in Form einer leitfähigen Folie auf, welche auf der hinteren, d.h. auf der vom Benutzer abgewandten, Seite der Blende in montiertem Zustand der Bedieneinheit positioniert ist. Dem Sensorelement ist ein Leuchtmittel, beispielsweise in Form einer LED, zugeordnet, wobei das von der LED seitlich bzw. parallel zur Blende ausgestrahlte Licht durch einen Lichtleiter in Richtung der Blende umgelenkt und gestreut wird. Der Lichtleiter ist bündig, von der Blende aus gesehen hinter dem Sensorelement angeordnet. Da das Sensorelement durchsichtig ist, kann es auf diese Weise hinterleuchtet bzw. hintergrundbeleuchtet werden. Die LED und der Lichtleiter sind auf einer der Blende zugewandten Seite einer Leiterplatte angeordnet. Das Sensorelement wird über zugehörige Kontaktmittel bzw. Steckverbinder mit der Leiterplatte kontaktiert, wobei das am Sensorelement anstehende Sensorsignal durch Leiterbahnen der Leiterplatte einer Steuereinheit zur Auswertung zugeführt wird.

Wenn eine derartige Bedieneinheit in einem Randbereich der Glaskeramikplatte oder außerhalb der Glaskeramikplatte angeordnet werden soll, muss eine Gesamtbauhöhe des Bedienelements, die sich aus der Summe der Dicke der Leiterplatte, der Höhe bzw. der Dicke des Lichtleiters und der Dicke des Sensorelements ergibt, beispielsweise kleiner als 4mm sein. Dies ist mit der in der DE 103 26 684 A1 gezeigten Bedieneinheit jedoch nur schwer zu realisieren, da die Höhe bzw. Dicke des Lichtleiters aufgrund der gewünschten Abbildungseigenschaften nicht beliebig reduzierbar ist.

Weiterhin erfordert die gezeigte Bedieneinheit eine spezielle Schnittstelle bzw. einen speziellen Steckverbinder zwischen Sensorelement und Leiterplatte.

Die EP 1 542 363 A1 zeigt ein Tastenfeld für Automaten, bei dem ein Leuchtmittel hinter einer Durchtrittsöffnung einer Leiterplatte angeordnet ist.

Die EP 1 355 425 A2 zeigt eine Bedieneinheit, bei der ein Leuchtmittel einem Sensorelement zugeordnet ist, wobei ein Lichtleiter eine Richtungsänderung des Lichts bewirkt, das durch das Leuchtmittel erzeugt wird.

### Aufgabe und Lösung

Der Erfindung liegt die Aufgabe zugrunde, eine Bedieneinheit für Haushaltsgeräte der eingangs genannten Art zur Verfügung zu stellen, die eine sehr geringe Bauhöhe aufweist und die eine vergleichsweise einfache Kontaktierung des Sensorelements mit der Leiterplatte ermöglicht.

Die Erfindung löst diese Aufgabe durch eine Bedieneinheit nach Anspruch 1. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Die Bedieneinheit weist mindestens ein Sensorelement zum Erzeugen eines betätigungsabhängigen Sensorsignals, mindestens ein dem Sensorelement zugeordnetes Leuchtmittel, mindestens einen dem Leuchtmittel zugeordneten Lichtleiter, der eine Richtungsänderung des in den Lichtleiter eintretenden Lichts bezogen auf das aus dem Lichtleiter austretende Licht bewirkt, und eine Leiterplatte auf, auf der das Leuchtmittel, das Sensorelement und der Lichtleiter angeordnet sind. Erfindungsgemäß ist das Leuchtmittel auf einer der Blende abzuwendenden Seite der Leiterplatte angeordnet, d.h. auf derjenigen Seite der Leiterplatte, die von der Blende im eingebauten Zustand der Bedieneinheit abgewandt ist. Der Lichtleiter ist zumindest teilweise in einer Durchtrittsöffnung der Leiterplatte, beispielsweise mit rundem oder ovalem Querschnitt, angeordnet bzw. durch die Durchtrittsöffnung durchgesteckt. Der Lichtleiter weist an einer der Blende zuzuwendenden Seite eine leitfähige, im Wesentlichen ebene Oberfläche auf, durch die das Sensorelement zumindest teilweise gebildet ist. Die Anordnung des Lichtleiters in der Öffnung der Leiterplatte reduziert die benötigte Bauhöhe um die Dicke der Leiterplatte verglichen mit der in der DE 103 26 684 A1 gezeigten Ausführungsform. Die leitfähige Oberfläche des Lichtleiters bildet mindestens teilweise das Sensorelement, wodurch sich die wirksame Sensorfläche im Vergleich zu einem Fall vergrößern lässt, bei dem ausschließlich leitfähige Flächen auf der Leiterplatte als Sensorelement vorgesehen sind.

In einer Weiterbildung ist das Sensorelement ein kapazitives Sensorelement zum Erzeugen einer betätigungsabhängigen Kapazität. Die leitfähige Oberfläche des Lichtleiters bildet hierbei eine Platte eines Kondensators.

In einer Weiterbildung ist die leitfähige Oberfläche durch Beschichten des Lichtleiters an der der Blende zuzuwendenden Seite mit einer leitfähigen, zumindest in Bereichen durchsichtigen Schicht gebildet. Die Schicht kann beispielsweise durch Bedrucken oder Bedampfen auf den Lichtleiter aufgebracht werden. Ein mögliches Schichtmaterial ist Indiumzinnoxid (ITO). Wenn nicht-durchsichtige Bereiche auf der Oberfläche des Lichtleiters vorgesehen sind, können diese zur Darstellung von Zeichen, Symbolen usw. verwendet werden.

In einer Weiterbildung ist der Lichtleiter elektrisch leitend. Auf diese Weise erfüllt der Lichtleiter eine Doppelfunktion als Lichtleiter und als Sensorelement. Eine Beschichtung mit einer leitfähigen Schicht ist in diesem Fall nicht notwendig.

In einer Weiterbildung beträgt die Richtungsänderung des in den Lichtleiter eintretenden Lichts bezogen auf das aus dem Lichtleiter austretende Licht 90 Grad. Auf diese Weise kann beispielsweise ein durch eine so genannte Side-LED erzeugtes Licht durch den Lichtleiter in Richtung der Blende umgelenkt und gestreut werden, so dass sich trotz der im Wesentlichen punktförmigen Strahlungsquelle eine flächig hinterleuchtete Taste ergibt.

In einer Weiterbildung ist das Leuchtmittel eine LED.

In einer Weiterbildung sind an den Lichtleiter angrenzende Flächen der Leiterplatte elektrisch leitfähig beschichtet.

In einer Weiterbildung sind an die Leiterplatte angrenzende Flächen des Lichtleiters elektrisch leitfähig beschichtet. Auf diese Weise ist in Kombination mit einer entsprechend leitfähigen Beschichtung der korrespondierenden Flächen der Leiterplatte ein einfache und zuverlässige Kontaktierung des Sensorelements bzw. der leitfähigen Oberfläche des Lichtleiters mit der Leiterplatte möglich, ohne dass hierzu spezifische Steckverbinder oder dergleichen notwendig sind.

In einer Weiterbildung ist um die Durchtrittsöffnung, auf der der Blende zuzuwendenden Seite eine leitfähige Kontaktfläche auf der Leiterplatte vorgesehen, die elektrisch mit der leitfähigen Oberfläche des Lichtleiters kontaktiert ist, wobei die leitfähige Oberfläche des Lichtleiters und die Kontaktfläche das Sensorelement bilden. Derartige Kontaktflächen können auch auf beiden Seiten der Leiterplatte im Bereich der Durchtrittsöffnung vorgesehen sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: einen Schnitt durch einen Teil einer Bedieneinheit für Kochfelder gemäß einer ersten Ausführungsform,
- Fig. 2: einen Schnitt durch einen Teil einer Bedieneinheit für Kochfelder gemäß einer weiteren Ausführungsform mit einer einseitig kupferbeschichteten Leiterplatte und
- Fig. 3: einen Schnitt durch einen Teil einer Bedieneinheit für Kochfelder gemäß einer weiteren Ausführungsform, bei der der Lichtleiter selbst leitfähig ist.

### Detaillierte Beschreibung der Ausführungsbeispiele

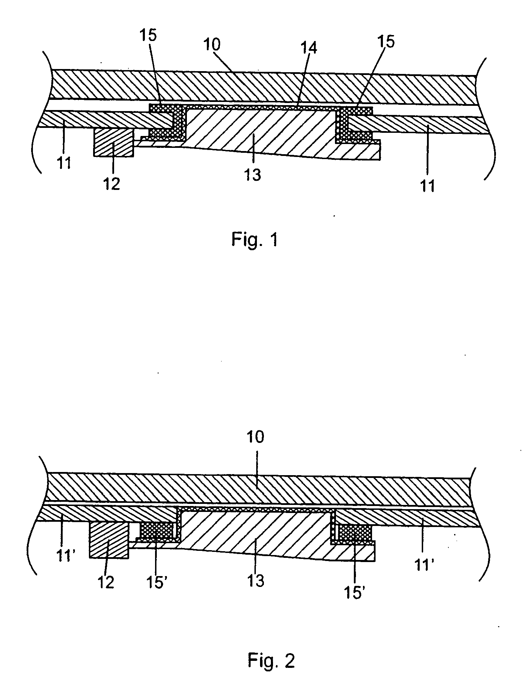

Fig. 1 zeigt einen Schnitt durch einen Teil einer Bedieneinheit für Kochfelder zum Einbau hinter einer Blende in Form einer Glaskeramikplatte 10 des Kochfeldes gemäß einer ersten Ausführungsform. Die Bedieneinheit dient beispielsweise zum Auswählen einer Kochstelle und zur Leistungsauswahl einer jeweiligen Kochstelle.

Um die Beschreibung zu vereinfachen, sind von der Bedieneinheit lediglich die erfindungswesentlichen Elemente dargestellt. Es versteht sich, dass neben den gezeigten Elementen noch weitere, nicht gezeigte Elemente vorgesehen sein können, beispielsweise weitere Sensorelemente, weitere LEDs, Schnittstellen und/oder ein Mikroprozessor zur Auswertung von Sensorsignalen.

Die gezeigte Bedieneinheit umfasst eine Leiterplatte 11 als Trägermedium für ein kapazitives Sensorelement zum Erzeugen eines betätigungsabhängigen Sensorsignals, für ein dem Sensorelement zugeordnetes Leuchtmittel in Form einer LED 12 und für einen dem Leuchtmittel zugeordneten Lichtleiter 13, der eine Richtungsänderung des in den Lichtleiter 13 eintretenden Lichts, das durch die LED 12 erzeugt wird, bezogen auf das aus dem Lichtleiter in Richtung der Blende 10 austretende Licht um ca. 90 Grad und eine gleichmäßige flächige Ausleuchtung der der Blende zugewandten Oberfläche des Lichtleiters bewirkt.

Die LED 12 ist auf einer Unterseite der Leiterplatte 11 angeordnet, d.h. auf einer der Blende 10 im montierten Zustand der Bedieneinheit abgewandten Seite der Leiterplatte 11.

Der Lichtleiter 13 ist in einer ovalen Durchtrittsöffnung der Leiterplatte 11 angeordnet bzw. durch diese mit seinem oberen Bereich hindurch gesteckt. Der Lichtleiter 13 füllt die Durchtrittsöffnung vollständig aus.

Der Lichtleiter 13 weist an einer der Blende 10 zugewandten Seite eine mit einer leitfähigen, durchsichtigen Beschichtung 14 versehene, ebene Oberfläche auf, die Teil des kapazitiven Sensorelements ist bzw. dieses teilweise bildet. Diese Oberfläche des Lichtleiters kann zusätzlich eine nicht lichtdurchlässige Bedruckung, eine Maske etc. aufweisen, die in Blendenrichtung oberhalb von der leitfähigen Beschichtung 14 angebracht ist. Auf diese Weise lassen sich beliebige Symbole, Zeichen etc. erzeugen.

An die Leiterplatte 11 angrenzende Flächen des Lichtleiters 13 sind ebenfalls mit der leitfähigen, durchsichtigen Beschichtung 14 versehen, d.h. sie sind elektrisch leitfähig beschichtet.

An den Lichtleiter 13 angrenzende, senkrecht ausgerichtete Flächen der Leiterplatte 11, d.h. die Seitenwände der Durchtrittsöffnung, und waagrechte Kontaktflächen in einem Bereich um die Durchtrittsöffnung auf der Oberseite und der Unterseite der Leiterplatte 11 sind leitfähig beschichtet und bewirken, dass die leitfähige durchsichtige Schicht 14 elektrisch mit den angrenzenden leitfähigen Flächen bzw. Schichten der Leiterplatte 11 verbunden ist. Dies hat einerseits zur Folge, dass die leitfähige Oberfläche 14 des Lichtleiters 13 und die Kontaktflächen 15 das kapazitive Sensorelement bilden. Weiterhin kann auf diese Weise ohne weitere Steckverbinder eine Kontaktierung der leitfähigen Schicht 14 mit der Leiterplatte erfolgen, wobei durch zugehörige nicht gezeigte Leiterbahnen der Leiterplatte ein Sensorsignal einer nicht gezeigten Auswerteeinheit zugeführt wird.

Fig. 2 zeigt einen Schnitt durch einen Teil einer Bedieneinheit für Kochfelder gemäß einer weiteren Ausführungsform mit einer einseitig kupferbeschichteten Leiterplatte 11'. Die Leiterplatte ist aus Kostengründen nur auf ihrer Unterseite, d.h. auf der von der Blende 10 abgewandten Seite, kupferbeschichtet. Eine elektrische Kontaktierung der Leiterplatte mit der leitfähigen Schicht 14 des Lichtleiters 13 erfolgt über Kontaktflächen 15' auf der Unterseite, die einen leitfähigen Flansch im Bereich um die Durchtrittsöffnung bilden. Im Übrigen entspricht die in Fig. 2 gezeigte Ausführungsform der in Fig. 1 gezeigten Ausführungsform.

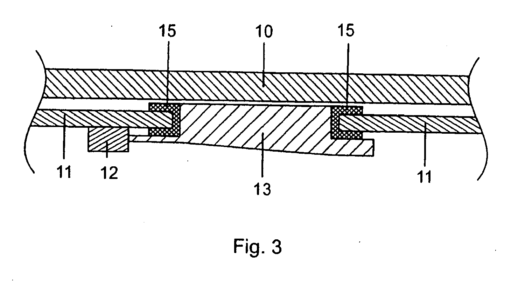

Fig. 3 zeigt einen Schnitt durch einen Teil einer Bedieneinheit für Kochfelder gemäß einer weiteren Ausführungsform, bei der der Lichtleiter selbst leitfähig ist. Bei dieser Ausführungsform kann die leitfähige Schicht 14 auf dem Lichtleiter 13 entfallen, da der Lichtleiter 13 selbst leitfähig ist.

Bei den gezeigten Ausführungsformen ist ein einzelnes Leuchtmittel 12 gezeigt, welches einem Lichtleiter 13 zugeordnet ist, der auf seiner der Blende 10 zugewandten Austrittsseite bzw. Austrittsfläche eine flächige Abbildung der Punktstrahlungsquelle 13 bewirkt. Zusätzlich oder alternativ können pro Lichtleiter 13 mehrere Leuchtmittel vorgesehen sein, die ihr Licht in eine oder mehrere Eintrittsöffnungen einspeisen, das wiederum aus einer oder mehren Austrittsöffnungen bzw. Austrittsflächen des Lichtleiters abgegeben wird. Auf diese Weise können beispielsweise mehrere Farben durch den Lichtleiter ausgegeben werden oder es kann eine Helligkeitsanpassung des durch den Lichtleiter abgegebenen Lichts erfolgen. Weiterhin lassen sich durch Gruppen von Austrittsöffnungen Symbole, Zeichen und/oder Formen etc. selektiv beleuchten. D.h. es lassen sich durch konstruktive Ausgestaltungen des Lichtleiters beliebige, gewünschte Lichteffekte erzeugen.

Der Lichtleiter bzw. die Durchtrittsöffnung weist in einer Draufsicht eine ovale Form auf. Es versteht sich, dass der Lichtleiter bzw. die Durchtrittsöffnung beliebige Formen aufweisen kann, beispielsweise rund, rechteckig oder dreieckig.

Die gezeigten Ausführungsformen weisen eine geringe Bauhöhe trotz einer flächigen Hintergrundbeleuchtung einer durch das Sensorelement gebildeten Taste auf, da aufgrund der Anordnung des Lichtleiters 13 in der Durchtrittsöffnung der Leiterplatte 11 die Gesamtbauhöhe um die Leiterplattendicke verglichen mit einer herkömmlichen Ausführungsform reduziert wird. Dies ermöglicht einen Einbau einer erfindungsgemäßen Bedieneinheit in einem Randbereich oder außerhalb eines Glaskeramikbereichs eines Kochfelds. Weiterhin wird eine Kontaktierung des Sensorelements mit der Leiterplatte vereinfacht, da keine speziellen Steckverbinder benötigt werden.

## Patentansprüche

1. Bedieneinheit für Haushaltsgeräte, insbesondere für Kochfelder, zum Einbau hinter einer Blende (10) des Haushaltsgeräts mit
- mindestens einem Sensorelement (14) zum Erzeugen eines betätigungsabhängigen Sensorsignals,
- mindestens einem dem Sensorelement (14) zugeordneten Leuchtmittel (12),
- mindestens einem dem Leuchtmittel (12) zugeordneten Lichtleiter (13), der zumindest teilweise in einer Durchtritts-öffnung einer Leiterplatte (11) angeordnet ist, und
- der Leiterplatte (11), auf der der Lichtleiter (13) und das Sensorelement (14, 15) angeordnet sind,
**dadurch gekennzeichnet, dass**
- der Lichtleiter (13) eine Richtungsänderung des in den Lichtleiter (13) eintretenden Lichts bezogen auf das aus dem Lichtleiter (13) austretende Licht bewirkt,
- das Leuchtmittel (12) auf einer der Blende (10) abzuwendenden Seite der Leiterplatte (11) angeordnet ist und
- der Lichtleiter (13) an einer der Blende (10) zuzuwendenden Seite eine leitfähige, im Wesentlichen ebene Oberfläche (14) aufweist, wobei das Sensorelement zumindest teilweise durch die leitfähige Oberfläche (14) gebildet ist.

2. Bedieneinheit nach Anspruch 1, **dadurch gekennzeichnet, dass** das Sensorelement ein kapazitives Sensorelement (14) zum Erzeugen einer betätigungsabhängigen Kapazität ist.

3. Bedieneinheit nach Anspruch 1 oder 2, **dadurch gekennzeichnet, dass** die leitfähige Oberfläche durch Beschichten des Lichtleiters an der der Blende (10) zuzuwendenden Seite mit einer leitfähigen, zumindest in Bereichen durchsichtigen Schicht (14) gebildet ist.

4. Bedieneinheit nach einem der vorhergehenden Ansprüche, **dadurch gekennzeichnet, dass** der Lichtleiter (13) elektrisch leitend ist.

5. Bedieneinheit nach einem der vorhergehenden Ansprüche, **dadurch gekennzeichnet, dass** die Richtungsänderung des in den Lichtleiter (13) eintretenden Lichts bezogen auf das aus dem Lichtleiter (13) austretende Licht 90 Grad beträgt.

6. Bedieneinheit nach einem der vorhergehenden Ansprüche, **dadurch gekennzeichnet, dass** das Leuchtmittel eine LED (12) ist.

7. Bedieneinheit nach einem der vorhergehenden Ansprüche, **dadurch gekennzeichnet, dass** an den Lichtleiter (13) angrenzende Flächen (15) der Leiterplatte (11) elektrisch leitfähig beschichtet sind.

8. Bedieneinheit nach einem der vorhergehenden Ansprüche, **dadurch gekennzeichnet, dass** an die Leiterplatte (11) angrenzende Flächen des Lichtleiters elektrisch leitfähig beschichtet sind.

9. Bedieneinheit nach einem der vorhergehenden Ansprüche, **dadurch gekennzeichnet, dass** um die Durchtrittsöffnung, auf der der Blende zuzuwendenden Seite eine leitfähige Kontaktfläche (15) auf der Leiterplatte vorgesehen ist, die elektrisch mit der leitfähigen Oberfläche (14) des Lichtleiters (13) kontaktiert ist, wobei die leitfähige Oberfläche (14) des Lichtleiters (13) und die Kontaktfläche (15) das Sensorelement bilden.

## Claims

1. A control unit for domestic appliances, in particular for cooktops, for installation behind a cover (10) of the domestic appliance, having
- at least one sensor element (14) for generating an actuation-dependent sensor signal,
- at least one luminous means (12) associated with the sensor element (14),
- at least one light guide (13) associated with the luminous means (12), said light guide at least partially associated with an aperture opening of a circuit board (11), and
- the circuit board (11) on which the light guide (13) and the sensor element (14, 15) are arranged,
**characterized in that**
- the light guide (13) is for changing the direction of the light entering the light guide (13) with respect to the light emitted by the light guide (13),
- the luminous means (12) is arranged on a side of the circuit board (11) which is intended to face away from the cover (10), and
- the light guide (13) has a conductive, substantially flat surface (14) on a side intended to face the cover (10), with the sensor element being formed at least in part by the conductive surface (14).

2. The control unit as claimed in claim 1, **characterized in that** the sensor element is a capacitive sensor element (14) for generating an actuation-dependent capacitance.

3. The control unit as claimed in claim 1 or 2, **characterized in that** the conductive surface is formed by coating the light guide on the side which is intended to face the cover (10) with a conductive coating (14) which is transparent at least in parts.

4. The control unit as claimed in any of the preceding claims, **characterized in that** the light guide (13) is electrically conductive.

5. The control unit as claimed in any of the preceding claims, **characterized in that** the directional change of the light entering the light guide (13) with respect to the light emitted by the light guide (13) is 90 degrees.

6. The control unit as claimed in any of the preceding claims, **characterized in that** the luminous means is an LED (12).

7. The control unit as claimed in any of the preceding claims, **characterized in that** areas (15) of the circuit board (11) adjacent to the light guide (13) are coated to be electrically conductive.

8. The control unit as claimed in any of the preceding claims, **characterized in that** areas on the light guide adjacent to the circuit board (11) are coated to be electrically conductive.

9. The control unit as claimed in any of the preceding claims, **characterized in that** a conductive contact surface (15) is provided around the aperture opening on the circuit board on the side which is intended to face the cover, the conductive contact surface (15) being electrically connected with the conductive surface (14) of the light guide (13), with the conductive surface (14) of the light guide (13) and the contact surface (15) forming the sensor element.

## Revendications

1. Unité de commande pour appareils ménagers, en particulier pour tables de cuisson, destinée à être installée derrière un diaphragme (10) de l'appareil ménager, comportant :
- au moins un élément capteur (14) destiné à générer un signal de capteur en fonction de l'actionnement,
- au moins un moyen générateur de lumière (12) associé à l'élément capteur (14),
- au moins un guide de lumière (13) associé au moyen générateur de lumière (12), lequel guide de lumière est au moins partiellement disposé dans une ouverture de passage d'une carte de circuit imprimé (11), et
- la carte de circuit imprimé (11), sur laquelle sont disposés le guide de lumière (13) et l'élément capteur (14, 15),
**caractérisée en ce que**
- le guide de lumière (13) provoque un changement de direction de la lumière pénétrant dans le guide de lumière (13) par rapport à la lumière sortant du guide de lumière (13),
- le moyen générateur de lumière (12) est disposé sur une face de la carte de circuit imprimé (11) devant être tournée à l'opposé du diaphragme (10), et
- le guide de lumière (13), sur une face devant être tournée vers le diaphragme (10), présente une surface (14) sensiblement plane et conductrice, dans laquelle l'élément capteur est formé au moins partiellement à travers la surface conductrice (14).

2. Unité de commande selon la revendication 1, **caractérisée en ce que** l'élément capteur est un élément capteur capacitif (14) destiné à générer une capacité dépendant de l'actionnement.

3. Unité de commande selon la revendication 1 ou 2, **caractérisée en ce que** la surface conductrice est réalisée en revêtant le guide de lumière sur la face devant être tournée vers le diaphragme (10) d'une couche (14) conductrice transparente dans au moins certaines zones.

4. Unité de commande selon l'une quelconque des revendications précédentes, **caractérisée en ce que** le guide de lumière (13) est électriquement conducteur.

5. Unité de commande selon l'une quelconque des revendications précédentes, **caractérisée en ce que** le changement de direction de la lumière pénétrant dans le guide de lumière (13) par rapport à la lumière sortant du guide de lumière (13) est de 90 degrés.

6. Unité de commande selon l'une quelconque des revendications précédentes, **caractérisée en ce que** le moyen générateur de lumière est une LED (12).

7. Unité de commande selon l'une quelconque des revendications précédentes, **caractérisée en ce que** des surfaces adjacentes (15) de la carte de circuit imprimé (11) adjacentes au guide de lumière (13), sont revêtues de manière électriquement conductrice.

8. Unité de commande selon l'une quelconque des revendications précédentes, **caractérisée en ce que** des surfaces du guide de lumière adjacentes à la carte de circuit imprimé (11) sont revêtues de manière électriquement conductrice.

9. Unité de commande selon l'une quelconque des revendications précédentes, **caractérisée en ce que**, du côté devant être tourné vers le diaphragme, il est prévu sur la carte de circuit imprimé, autour de l'ouverture de passage, une surface de contact conductrice (15) qui est mise en contact électrique avec la surface conductrice (14) du guide de lumière (13), dans laquelle la surface conductrice (14) du guide de lumière (13) et la surface de contact (15) forment l'élément capteur.
